# EUROPEAN PATENT SPECIFICATION

(11) **EP 3 187 928 B1**
(45) Date of publication and mention of the grant of the patent: **14.10.2026**
(21) Application number: 16206589.0
(22) Date of filing: 23.12.2016
(51) Int. Cl.: G02F 1/1345, G09G 3/3266, G09G 3/36

(54) **DISPLAY DEVICE**
ANZEIGEVORRICHTUNG
AFFICHEUR

(30) Priority: 31.12.2015 KR 20150191218
(43) Date of publication of application: 05.07.2017
(73) Proprietor: LG Display Co., Ltd., Seoul 07336 (KR)
(72) Inventor: LEE, JungHyun, 10845 Gyeonggi-do (KR)
(74) Representative: Morrall, Jonathan Ian McLachlan

(56) References cited:
- EP-A1- 3 193 325
- EP-A2- 2 690 490
- CN-A- 104 849 928
- KR-A- 20130 135 043
- US-A1- 2010 176 395
- US-A1- 2015 279 258
- US-A1- 2015 310 821
- US-A1- 2016 307 517
- US-A1- 2016 307 937

## Description

### BACKGROUND

### Field of the Disclosure

The present disclosure relates to a display device, and more particularly, to a display device with a gate in panel (GIP) structure, that is, a display device with a gate driver provided in a panel. Although the present disclosure is suitable for a wide scope of applications, it is particularly suitable for implementing a display device having a narrow bezel width without sacrificing an aperture ratio.

### Discussion of the Background

A display device such as a liquid crystal display device and an organic light emitting display device includes a display area for displaying an image, and a non-display area formed in the periphery of the display area. Herein, a plurality of pixels is provided in the display area for displaying an image, and a driver for driving the plurality of pixels is provided in the non-display area.

The driver includes a gate driver for applying a gate signal to a gate line in the display area, and a data driver for applying a data signal to a data line in the display area.

The gate driver includes a gate integrated circuit for applying the gate signal to each of the plurality of gate lines, and the data driver includes a data integrated circuit for applying the data signal to each of the plurality of data lines.

Generally, the gate integrated circuit and the data integrated circuit are manufactured in a type of chip, and are mounted on a film (i.e., chip on film) or mounted on a substrate (i.e., chip on glass). However, if the gate integrated circuit and the data integrated circuit are manufactured in a type of chip, it causes the increase in manufacturing cost due to the increase in the number of elements. Also, it has limitation on lightness in weight of display device. Thus, it has been proposed a gate in panel (GIP) structure in which the gate integrated circuit is directly formed on the substrate without manufacturing the gate integrated circuit as a type of chip.

Hereinafter, a related art display device with a GIP structure will be described with reference to the accompanying drawings.

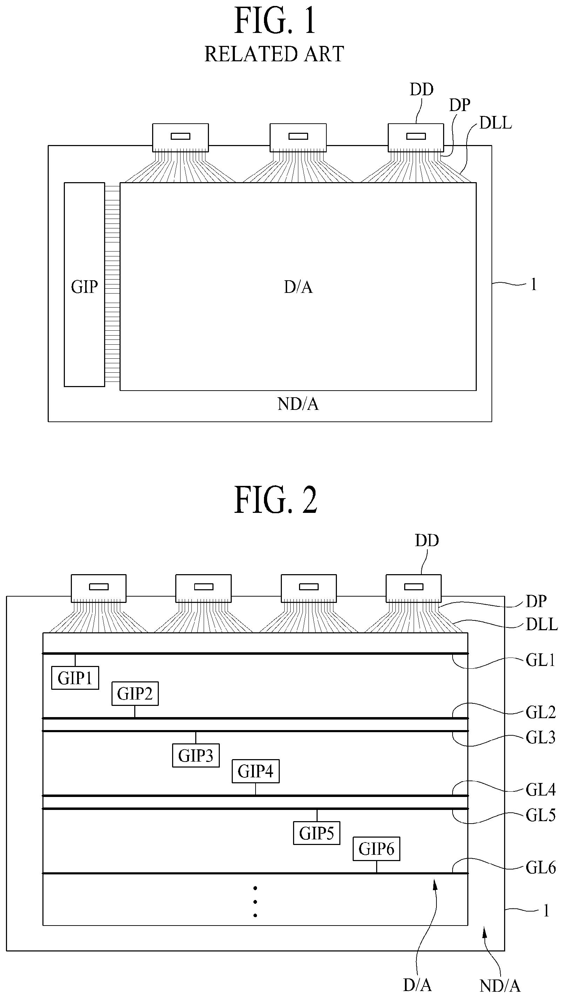

FIG. 1 is a plane view illustrating a related art display device.

As shown in FIG. 1, the related art display device includes a display area (D/A) and a non-display area (ND/A) on a substrate 1.

Although not shown in detail, a plurality of pixels are disposed in the display area (D/A), wherein the pixels are defined by crossing gate and data lines, and a thin film transistor and a pixel electrode are located in each pixel.

In the non-display area (ND/A), there is a GIP circuit (GIP) for applying a gate signal to the gate line. The GIP circuit (GIP) includes a plurality of thin film transistors.

In the non-display area (ND/A), there are a data link line (DLL), a data pad (DP), and a data driver (DD), so as to apply a data signal to the data line. The data link line (DLL) connects the data line and the data pad (DP) with each other, and the data driver (DD) is connected with the data pad (DP).

In the related art display device, the GIP circuit (GIP) is provided at one side of the display area (D/A), for example, a left peripheral region, and the data link line (DLL), the data pad (DP), and the data driver (DD) are provided at the other side of the display area (D/A), for example, an upper peripheral region, whereby it has limitations on decrease in the non-display area (ND/A).

In order to satisfy a user's demand for various designs, a method for decreasing a bezel width corresponding to the non-display area (ND/A) of the display device has been studied recently. However, in the related art display device with the GIP structure, it has limitations on decrease in the non-display area (ND/A), whereby it is difficult to realize a narrow bezel width.

EP 2 690 490 A2 describes a substantially rectangular display panel which includes a first edge extending in a first major axis direction of the rectangular shape and a second edge extending in a second major axis direction of the rectangular shape.

US 2016/307517 A1 describes a display device which includes a plurality of pixels disposed in an display area, and a pixel driver connected to at least two of the pixels, wherein the pixel driver drives the at least two pixels, where a portion of the pixel driver is disposed in the display area, and the display device includes the display area, on which an image is displayed, and a non-display area, on which no image is displayed.

US 2015/310821 A1 describes a display device which includes a display substrate, on which a display area and a non-display area are defined, a plurality of gate lines arranged in the display area to extend in a first direction, a gate driving unit including a plurality of stages which outputs gate signals to the plurality of gate lines, and a plurality of pixel rows disposed in the display area and connected to the plurality of gate lines, where a driving area and an electrode area are defined in the display area between two adjacent pixel rows in a second direction among the plurality of pixel rows, at least a part of the plurality of stages is disposed in the driving area, and a compensation electrode is disposed in the electrode area.

US 2016/306937 A1 describes thin-film transistor, array substrate and display apparatus.

EP 3 193 325 A1 describes a liquid crystal display device includes a display panel including a display area and a non-display area.

### SUMMARY

Accordingly, the present disclosure is directed to a display device that substantially obviates one or more problems due to limitations and disadvantages of the related art.

An aspect of the present disclosure is to provide a display device which is capable of realizing a GIP structure and also realizing a narrow bezel width.

Additional advantages and features of embodiments of the invention will be set forth in part in the description which follows and in part will become apparent to those having ordinary skill in the art upon examination of the following or may be learned from practice of embodiments of the invention. The objectives and other advantages of embodiments of the invention may be realized and attained by the structure particularly pointed out in the written description and claims hereof as well as the appended drawings.

To achieve these and other advantages and in accordance with the purpose of aspects of the present disclosure, as embodied and broadly described herein, there is provided a display device that includes a GIP circuit, provided on a display area of a substrate, for supplying gate signals to gate lines, wherein the GIP circuit includes a thin film transistor provided in the boundaries between adjacent pixels.

In another aspect of the present disclosure, a display device having a gate in panel structure comprises first and second gate lines on a display area and disposed to a first direction; first and second data lines on the display area and disposed to a second direction and the first and second gate lines and the first and second data lines crossing with each other; first and second pixels defined by the first and second gate lines and first and second data lines; a gate in panel (GIP) circuit supplying a gate signal to the first and second gate lines, the GIP circuit including a first thin film transistor disposed between the first and second pixels.

It is to be understood that both the foregoing general description and the following detailed description of the present disclosure are exemplary and explanatory and are intended to provide further explanation of embodiments of the disclosure as claimed.

### BRIEF DESCRIPTION OF THE DRAWINGS

The accompanying drawings, which are included to provide a further understanding of aspects of the disclosure and are incorporated in and constitute a part of this application, illustrate aspect(s) of the disclosure and together with the description serve to explain the principle of embodiments of the disclosure. In the drawings:
FIG. 1 is a plan view illustrating a related art display device;
FIG. 2 is a plan view illustrating a display device according to one aspect of the present disclosure;
FIG. 3 is a plan view illustrating a display device according to another aspect of the present disclosure;
FIG. 4 is a block diagram illustrating a GIP circuit according to one aspect of the present disclosure;
FIG. 5 is a circuit diagram illustrating a GIP circuit according to one aspect of the present disclosure;
FIG. 6 is a plan view illustrating a display area of the display device according to one aspect of the present disclosure;
FIG. 7 is a plan view illustrating a pixel structure of the display device according to one aspect of the present disclosure;
FIG. 8 is a cross sectional view along A-B line of FIG. 7, which shows the pixel structure of the display device according to one aspect of the present disclosure;
FIG. 9 is a cross sectional view along C-D line of FIG. 7, which shows the pixel structure of the display device according to one embodiment of the present disclosure; and
FIG. 10 is a cross sectional view along C-D line of FIG. 7, which shows the pixel structure of the display device according to another aspect of the present disclosure.

### DETAILED DESCRIPTION DISCLOSURE

Reference will now be made in detail to the exemplary embodiments of the present disclosure, examples of which are illustrated in the accompanying drawings. Wherever possible, the same reference numbers will be used throughout the drawings to refer to the same or like parts. Advantages and features of the present disclosure, and implementation methods thereof will be clarified through following embodiments described with reference to the accompanying drawings. The present disclosure may, however, be embodied in different forms and should not be construed as limited to the aspects set forth herein. Rather, these aspects are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing aspects of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted. In a case where 'comprise', 'have', and 'include' described in the present specification are used, another part may be added unless `only~' is used. The terms of a singular form may include plural forms unless referred to the contrary.

In construing an element, the element is construed as including an error range although there is no explicit description.

In description of aspects of the present disclosure, when a structure (for example, an electrode, a line, a wiring, a layer, or a contact) is described as being formed at an upper portion/lower portion of another structure or on/under the other structure, this description should be construed as including a case where the structures contact each other and moreover, a case where a third structure is disposed therebetween.

In describing a time relationship, for example, when the temporal order is described as 'after~', 'subsequent~', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Features of various aspects of the present disclosure may be partially or overall coupled to or combined with each other, and may be variously inter-operated with each other and driven technically as those skilled in the art can sufficiently understand. The aspects of the present disclosure may be carried out independently from each other, or may be carried out together in co-dependent relationship.

Hereinafter, a display device according to aspects of the present disclosure will be described in detail with reference to the accompanying drawings.

FIG. 2 is a plan view illustrating a display device according to one aspect of the present disclosure.

As shown in FIG. 2, the display device according to one aspect of the present disclosure may include a display area (D/A) and a non-display area (ND/A) on a substrate 1.

In the display area (D/A), there are a plurality of gate lines (GL1 ~ GL6) arranged in a first direction, for example, a latitudinal direction of the substrate 1, and a plurality of data lines (not shown) arranged in a second direction, for example, a longitudinal direction of the substrate 1. A plurality of pixel regions are defined by crossing the plurality of gate lines (GL1 ~ GL6) and the plurality of data lines (not shown). For convenience of explanation, FIG. 2 shows only six gate lines (GL1 ~ GL6).

In the display area (D/A), there are a plurality of GIP circuits (GIP1 ~ GIP6). The first GIP circuit (GIP1) supplies a gate signal to the first gate line (GL1), and each of the second to sixth GIP circuits (GIP2 ~ GIP6) supplies a gate signal to each of the second to sixth gate lines (GL2 ~ GL6).

According to one aspect of the present disclosure, the plurality of GIP circuits (GIP1 ~ GIP6) are provided in the display area (D/A) so that it is possible to decrease a size of the non-display area (ND/A), and to decrease a bezel width of the display device.

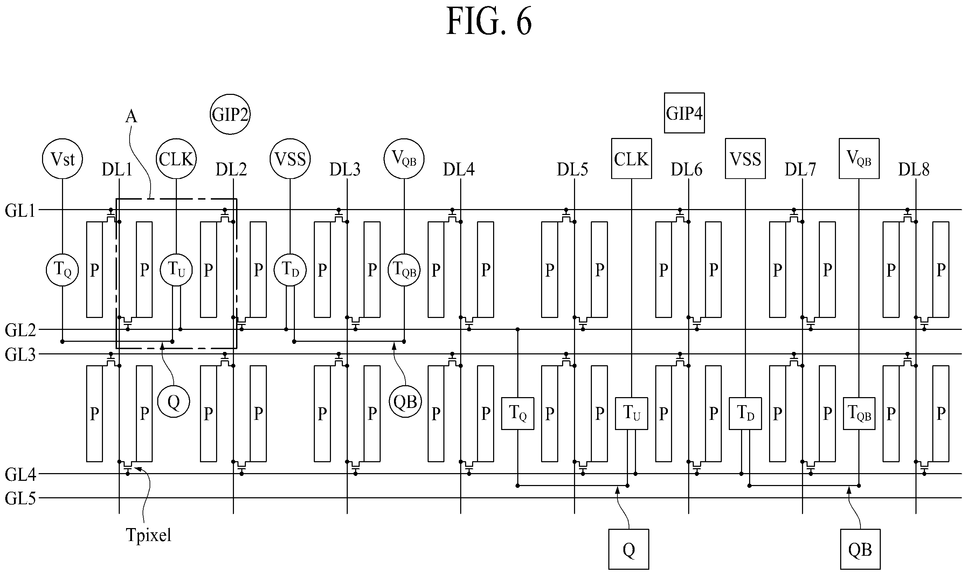

According to one aspect of the present disclosure, since the plurality of GIP circuits (GIP1 ~ GIP6) are provided in the display area (D/A), an area for the plurality of GIP circuits (GIP1 ~ GIP6) has to be formed in the display area (D/A). To this end, each pixel is formed at each of both sides of the data line (not shown), whereby the two pixels are driven by one data line (not shown). Thus, it is possible to prepare an area in which the data line (not shown) is not provided, and to provide the plurality of GIP circuits (GIP1 ~ GIP6) in this area without the data line (not shown). This will be described more fully with reference to FIG. 6.

In the non-display area (ND/A), there are a data link line (DLL), a data pad (DP), and a data driver (DD).

The data link line (DLL) is connected with the data line of the display area (D/A). Also, the data link line (DLL) may be connected with various signal lines for the GIP circuit (GIP1 ~ GIP6), for example, a clock signal (CLK) line, a low-potential voltage (VSS) line, a start signal (Vst) line, a reset signal (Vreset) line, and etc.

The data pad (DP) is connected with the data link line (DLL) and the data driver (DD) in a one-to-one correspondence.

The data driver (DD) is connected with the data pad (DP). The data driver (DD) includes a flexible printed circuit film (FPC film) in which a chip including a data integrated circuit is mounted, whereby it is possible to form a COF (Chip On Film) structure, but not limited to this structure. For example, the chip may be mounted on the substrate 10, to thereby form a COG (Chip On Glass) structure. Although not shown, the flexible printed circuit film (FPC film) is connected with a printed circuit board (PCB), whereby various signals are transmitted from the printed circuit board (PCB) to the flexible printed circuit film (FPC film).

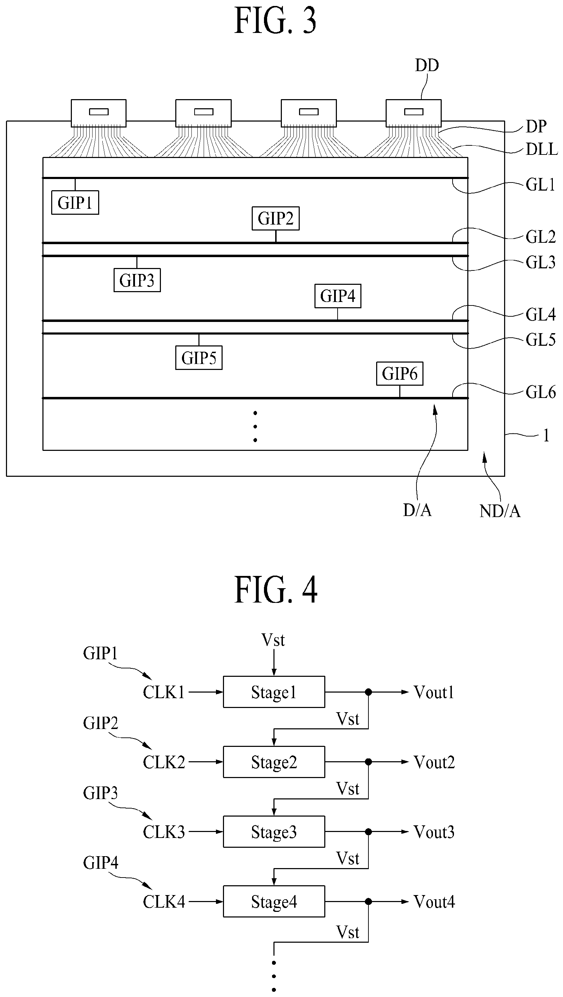

FIG. 3 is a plan view illustrating a display device according to another aspect of the present disclosure. Except for an arrangement of a plurality of GIP circuits (GIP1 ~ GIP6), the display device according to another aspect of the present disclosure shown in FIG. 3 is substantially the same as the display device according to one aspect of the present disclosure shown in FIG. 2. Accordingly, the same reference numbers will be used throughout the drawings to refer to the same or like parts, and only the different parts will be described in detail as follows.

Referring back to FIG. 2, the first to sixth GIP circuits (GIP1 ~ GIP6) are sequentially shifted at fixed intervals from one side of the substrate 1 to the other side of the substrate 1, for example, the left side of the substrate 1 to the right side of the substrate 1.

Meanwhile, in FIG. 3, the odd-numbered GIP circuits (GIP1, GIP3, GIP5) are disposed at the left-side area of the substrate 1 with respect to the center of the substrate 1, and the even-numbered GIP circuits (GIP2, GIP4, GIP6) are disposed at the right-side area of the substrate 1 with respect to the center of the substrate 1. Also, the odd-numbered GIP circuits (GIP1, GIP3, GIP5) are sequentially shifted at fixed intervals from one side of the substrate 1 to the other side of the substrate 1, for example, the left side of the substrate 1 to the right side of the substrate 1, and the even-numbered GIP circuits (GIP2, GIP4, GIP6) are sequentially shifted at fixed intervals from one side of the substrate 1 to the other side of the substrate 1, for example, the left side of the substrate 1 to the right side of the substrate 1.

The different signals, for example, the different clock signals (CLK) may be applied to the first to sixth GIP circuits (GIP1 ~ GIP6). In this case, the clock signal (CLK) may be applied via the clock signal line arranged in the longitudinal direction of the substrate, for example, the second direction which is the same as that of the data line in the area wherein the data line is not formed (See FIG. 6). In order to facilitate the structure of signal line, the first to sixth GIP circuits (GIP1 ~ GIP6) are not overlapped in the second direction wherein the data line is arranged, but not limited to this structure. It is possible to overlap the different GIP circuits (GIP1 ~ GIP6) with each other in the second direction.

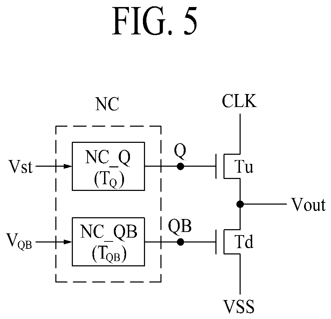

Hereinafter, the structure of GIP circuit will be described with reference to FIGs. 4 and 5. FIGs. 4 and 5 show one example of the GIP circuit which is capable of being applied to the present disclosure, but not limited to this structure.

FIG. 4 is a block diagram illustrating the GIP circuits (GIP1 ~ GIP6) according to one aspect of the present disclosure.

As shown in FIG. 4, each of the plurality of GIP circuits (GIP1 ~ GIP6) outputs and supplies a gate signal (Vout1 ~ Vout6) of a high state (High) to a gate line for one frame period.

In detail, the first GIP circuit (GIP1) is started by a separate start signal (Vst) in a first stage (stage1), and the first GIP circuit (GIP1) outputs a first gate signal (Vout1) of a high state generated using a first clock signal (CLK1), and supplies the first gate signal (Vout1) of the high state to the first gate line.

Each of the second to sixth GIP circuits (GIP2 ~ GIP6) is started by a start signal (Vst) corresponding to the gate signals (Vout1 ~ Vout5) of the GIP circuits (GIP1 ~ GIP5) of the prior stage in each of second to sixth stages (Stage2 ~ Stage6), and the second to sixth GIP circuits (GIP2 ~ GIP6) respectively output the second to sixth gate signals (Vout2 ~ Vout6) of a high state generated using second to sixth clock signals (CLK2 ~ CLK6), and respectively supply the second to sixth gate signals (Vout2 ~ Vout6) to the second to sixth gate lines.

Meanwhile, although not shown, when the final gate signal (Vout) is output from the stage of the final GIP circuit at which one frame is ended, the stage of the final GIP circuit is reset by a reset signal (Vreset). Then, the first gate signal (Vout1) is output from the first stage (stage1) of the first GIP circuit (GIP1) at which the next frame is started, and the aforementioned process is repeated.

FIG. 5 is a circuit diagram illustrating the GIP circuit according to one aspect of the present disclosure. Each of the plurality of GIP circuits (GIP1 ~ GIP6) shown in FIG. 4 may be the same as the circuit shown in FIG. 5, but not limited to this structure.

As shown in FIG. 5, the GIP circuit may include a pull-up node (Q), a pull-down node (QB), a pull-up transistor (Tu), a pull-down transistor (Td), and a node controller (NC).

The pull-up transistor (Tu) is turned-on when the pull-up node (Q) is charged with a gate high voltage, and the pull-down transistor (Td) is turned-on when the pull-down node (QB) is charged with the gate high voltage.

The node controller (NC) controls charging and discharging states in each of the pull-up node (Q) and the pull-down node (QB). To this end, the node controller (NC) may include a pull-up node controller (NC_Q) for controlling the charging and discharging states of the pull-up node (Q), and a pull-down node controller (NC_QB) for controlling the charging and discharging states of the pull-down node (QB). The pull-up node controller (NC_Q) may include at least one transistor (T_{Q}) for controlling the pull-up node (Q), and the pull-down node controller (NC_QB) may include at least one transistor (T_{QB}) for controlling the pull-down node (QB).

The node controller (NC) enables a stable output of the gate signal (Vout). In detail, if the pull-up node (Q) is charged with the gate high voltage, the pull-down node (QB) is discharged to a gate low voltage by the node controller (NC). If the pull-down node (QB) is charged with the gate high voltage, the pull-up node (Q) is discharged to the gate low voltage by the node controller (NC).

Accordingly, when the start signal (Vst) is applied, the plurality of transistors (T_{Q}, T_{QB}) included in the node controller (NC) are operated to charge the pull-up node (Q) with the gate high voltage and to discharge the pull-down node (QB) to the gate low voltage, to thereby output the gate signal (Vout) for the clock signal (CLK). Also, when a discharging signal (V_{QB}) is applied, the plurality of transistors (T_{Q},T_{QB}) included in the node controller (NC) are operated to discharge the pull-up node (Q) to the gate low voltage and to charge the pull-down node (QB) with the gate high voltage, to thereby output the gate signal (Vout) for the low-potential voltage (VSS).

Referring to the start signal (Vst), the first GIP circuit may use the separately-applied start signal (Vst), and the second to sixth GIP circuits may use the start signal (Vst) corresponding to the gate signal (Vout) which is output from the GIP circuit of the prior stage.

Referring to the discharging signal (V_{QB}), it is possible to use the gate signal (Vout) which is output from the prior stage for the discharging signal (V_{QB}), or to use a separate clock signal (CLK) for the discharging signal (V_{QB}).

At least one transistor (T_{Q}) included in the pull-up node controller (NC_Q) and at least one transistor (T_{QB}) included in the pull-down node controller (NC_QB) may be changed to various types generally known to those in the art.

FIG. 6 is a plan view illustrating the display area of the display device according to one aspect of the present disclosure.

As shown in FIG. 6, the display area of the display device according to one aspect of the present disclosure may include gate lines (GL1 ~ GL5), data lines (DL1 ~ DL8), a pixel transistor (Tpixel), a pixel electrode (P), and GIP circuits (GIP2, GIP4).

For convenience of explanation, FIG. 6 shows the second GIP circuit (GIP2) for supplying the gate signal to the second gate line (GL2), and the fourth GIP circuit (GIP4) for supplying the gate signal to the fourth gate line (GL4). Also, for convenience of explanation, elements for the second GIP circuit (GIP2) are shown in a type of circle shape, and elements for the fourth GIP circuit (GIP4) are shown in a type of quadrangle.

The plurality of gate lines (GL1 ~ GL5) are arranged in a latitudinal direction, and the plurality of data lines (DL1 ~ DL8) are arranged in a longitudinal direction. The pixel region is defined by the plurality of gate lines (GL1 ~ GL5) and the plurality of data lines (DL1 ~ DL8), and the pixel transistor (Tpixel) and the pixel electrode (P) are provided in the pixel region.

The pixel region is provided between a first gate line (GL1) and a second gate line (GL2), and between a third gate line (GL3) and a fourth gate line (GL4). But, the pixel region is not provided between the second gate line (GL2) and the third gate line (GL3). An interval between the second gate line (GL2) and the third gate line (GL3) is smaller than an interval between the first gate line (GL1) and the second gate line (GL2). And, an interval between the first gate line (GL1) and the second gate line (GL2) is the same as an interval between the third gate line (GL3) and the fourth gate line (GL4).

The two pixel transistors (Tpixel) which are positioned at both sides of each data line are respectively connected with one data line (DL1 ~ DL8). Accordingly, the respective pixels are provided at both sides of one data line (DL1 ~ DL8).

The pixel transistor (Tpixel) connected with one side of one data line (DL1 ~ DL8), for example, the left side of one data line is provided at the relatively high position to be connected with the gate lines (GL1, GL3, GL5), and the pixel transistor (Tpixel) connected with the other side of one data line (DL1 ~ DL8), for example, the right side of one data line is provided at the relatively low position to be connected with gate lines (GL2, GL4), whereby it is possible to prepare the two pixels with one data line (DL1 ~ DL8) and the two gate lines (GL1 ~ GL5). For example, in case of the area between the first gate line (GL1) and the second gate line (GL2), the pixels connected with the first data line (DL1) are provided at the left and right sides of the first data line (DL1), and the pixels connected with the second data line (DL2) are provided at the left and right sides of the second data line (DL2) positioned adjacent to the first data line (DL1). Thus, the data line (DL1 ~ DL8) is not formed between the pixel positioned at the right side of the first data line (DL1) and the pixel positioned at the left side of the second data line (DL2).

As described in FIG. 5, the GIP circuit (GIP2, GIP4) may include a start signal (Vst), a clock signal (CLK), a low-potential voltage (VSS), a discharging signal (V_{QB}), a pull-up transistor (Tu), a pull-down transistor (Td), a pull-up node (Q), a pull-down node (QB), a transistor (T_{Q}) for controlling the pull-up node (Q), and a transistor (T_{QB}) for controlling the pull-down node (QB). In FIG. 6, a separate start signal (Vst) is applied to the second GIP circuit (GIP2), and the fourth GIP circuit (GIP4) uses a start signal corresponding to the gate signal of the second gate line (GL2), but not necessarily. A structure of each of the GIP circuits (GIP2, GIP4) is the same as the aforementioned structure, whereby a detailed description for the structure of each GIP circuit will be omitted.

Signal lines for the start signal (Vst), the clock signal (CLK), the low-potential voltage (VSS), and the discharging signal (V_{QB}) are disposed in the area corresponding to the boundaries between the pixels, that is, the area in which the data line (DL1 ~ DL8) is not formed. Also, the pull-up transistor (Tu), the pull-down transistor (Td), the transistor (T_{Q}) for controlling the pull-up node (Q), and the transistor (T_{QB}) for controlling the pull-down node (QB) are disposed in the area corresponding to the boundaries between the pixels, that is, the area in which the data line (DL1 ~ DL8) is not formed.

According to one aspect of the present disclosure, the various signal lines and transistors for the GIP circuit (GIP2, GIP4) are disposed in the area corresponding to the boundaries between the pixels, that is, the area in which the data line (DL1 ~ DL8) is not formed, whereby it is possible to form the GIP circuit (GIP2, GIP4) in the display area, and thus to decrease a bezel width corresponding to the non-display area.

Especially, according as the various signal lines and transistors for the GIP circuit (GIP2, GIP4) are disposed in the area corresponding to the boundaries between the pixels, that is, the area in which the data line (DL1 ~ DL8) is not formed, there is no need to increase the size of pixel, and an aperture ratio is not lowered since the area corresponding to the boundaries between the pixels is not a light-transmission area. In order to prevent the aperture ratio from being lowered, one transistor for the GIP circuit (GIP2, GIP4) is disposed in the area corresponding to the respective boundaries between the pixels, that is, the area in which the data line (DL1 ~ DL8) is not formed.

FIG. 6 shows one transistor (T_{Q}) for controlling the pull-up node (Q), and one transistor (T_{QB}) for controlling the pull-down node (QB), but not necessarily. For example, the plurality of transistors (T_{Q}) for controlling the pull-up node (Q), which are formed in various shapes generally known to those in the art, may be connected with one another, and the plurality of transistors (T_{QB}) for controlling the pull-down node (QB), which are formed in various shapes generally known to those in the art, may be connected with one another. In this case, all the transistors (T_{Q}, T_{QB}) may not be disposed in the area corresponding to the respective boundaries between the pixels, that is, the area in which the data line (DL1 ~ DL8) is not formed, but one transistor (T_{Q}, T_{QB}) may be disposed in the area corresponding to the respective boundaries between the pixels, that is, the area in which the data line (DL1 ~ DL8) is not formed. Accordingly, the plurality of transistors (T_{Q}, T_{QB}) disposed in the boundaries between the different pixels may be connected through the pull-up node (Q), the pull-down node (QB), and the gate lines (GL1 ~ GL5).

The lines for the pull-up node (Q) and the pull-down node (QB) may be disposed in the latitudinal direction while being in parallel to the gate line (GL1 ~ GL5). Especially, the lines for the pull-up node (Q) and the pull-down node (QB) may be disposed in the area between the adjacent two gate lines (GL2, GL3), and more particularly, the area between the two gate lines (GL2, GL3) where the pixel is not provided, to thereby prevent the aperture ratio from being lowered.

The lines for the pull-up node (Q) and the pull-down node (QB) may be formed of the same material as that of the gate line (GL1 ~ GL5), and may be provided in the same layer as that of the gate line (GL1 ~ GL5). Thus, the lines for the pull-up node (Q) and the pull-down node (QB) may be manufactured without an additional process.

Hereinafter, an individual pixel structure will be described in detail as follows.

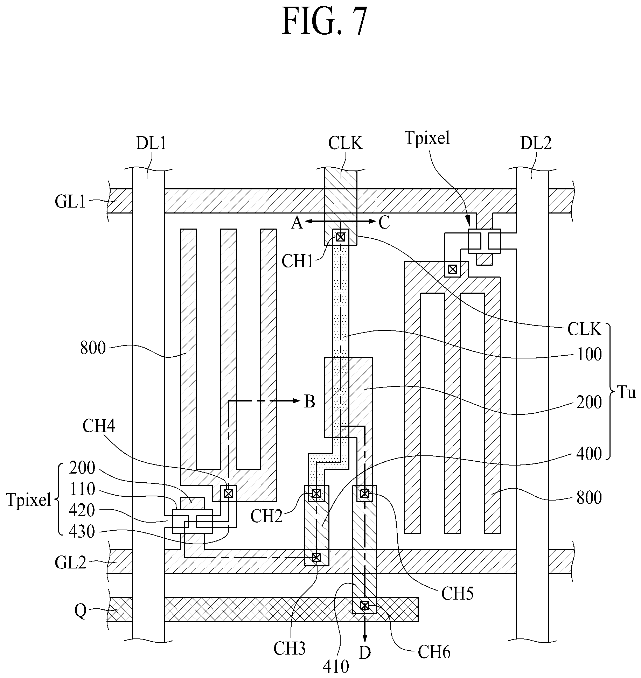

FIG. 7 is a plan view illustrating the pixel structure of the display device according to one aspect of the present disclosure. FIG. 7 is an expanded view illustrating 'A' of FIG. 6, which shows the area with the pull-up transistor (Tu).

As shown in FIG. 7, the first data line (DL1) and the second data line (DL2) which are adjacent to each other in the longitudinal direction are arranged in the area between the first gate line (GL1) and the second gate line (GL2) which are arranged in the latitudinal direction.

A pixel transistor (Tpixel) and a pixel electrode 800 are formed at the right side of the first data line (DL1), and another pixel transistor (Tpixel) and another pixel electrode 800 are formed at the left side of the second data line (DL2). The pixel transistor (Tpixel) formed at the right side of the first data line (DL1) is connected with the first data line (DL1) and the second gate line (GL2), and the pixel transistor (Tpixel) formed at the left side of the second data line (DL2) is connected with the second data line (DL2) and the first gate line (GL1), but not limited to this structure. For example, the pixel transistor (Tpixel) formed at the right side of the first data line (DL1) may be connected with the first data line (DL1) and the first gate line (GL1), and the pixel transistor (Tpixel) formed at the left side of the second data line (DL2) may be connected with the second data line (DL2) and the second gate line (GL2).

The pixel transistor (Tpixel) may include a gate electrode 200 connected with the gate line (GL1, GL2), an active layer 110 including an electron transfer channel, a source electrode 420 connected with the data line (DL1, DL2), and a drain electrode 430 facing the source electrode 420.

The pixel electrode 800 is connected with the drain electrode 430 of the pixel transistor (Tpixel) via a fourth contact hole (CH4). The pixel electrode 800 may be formed in a fork structure, but not limited to this structure.

The data line (DL1, DL2) is not formed in the area between the pixel electrode 800 formed at the right side of the first data line (DL1) and the pixel electrode 800 formed at the left side of the second data line (DL2). Instead of the data line (DL1, DL2), the clock signal (CLK) line and the pull-up transistor (Tu) are formed in the area between the pixel electrode 800 formed at the right side of the first data line (DL1) and the pixel electrode 800 formed at the left side of the second data line (DL2).

The clock signal (CLK) line is arranged in parallel to the data line (DL1, DL2).

The pull-up transistor (Tu) may include a gate electrode 200, an active layer 100, the clock signal (CLK) line serving as a source electrode, and a drain electrode 400.

The gate electrode 200 is connected with the pull-up node (Q) via a connection electrode 410. In detail, one end of the connection electrode 410 is connected with the gate electrode 200 via a fifth contact hole (CH5), and the other end of the connection electrode 410 is connected with the pull-up node (Q) line via a sixth contact hole (CH6).

The pull-up node (Q) line is arranged in the latitudinal direction, that is, the pull-up node (Q) line is formed at the same direction as the second gate line (GL) under the second gate line (GL). In this case, if the pull-up node (Q) line and the second gate line (GL) are formed at the same layer, it is impossible to extend the gate electrode 200 through the second gate line (GL) for the connection with the pull-up node (Q) line. Thus, the gate electrode 200 and the pull-up node (Q) line are connected with each other through the connection electrode 410. Accordingly, the connection electrode 410 is formed in the different layer from the gate electrode 200 and the pull-up node (Q) line.

The clock signal (CLK) line serving as the source electrode is connected with one end of the active layer 100 via a first contact hole (CH1). The drain electrode 400 is connected with the other end of the active layer 100 via a second contact hole (CH2), and is connected with the second gate line (GL2) via a third contact hole (CH3).

In case of the pull-up transistor (Tu), if the high voltage is applied to the gate electrode 200 through the pull-up node (Q) line, the clock signal (CLK), which is transmitted through the clock signal (CLK) line corresponding to the source electrode, is supplied to the second gate line (GL2) through the drain electrode 400. As a result, the gate signal is provided to the second gate line (GL2).

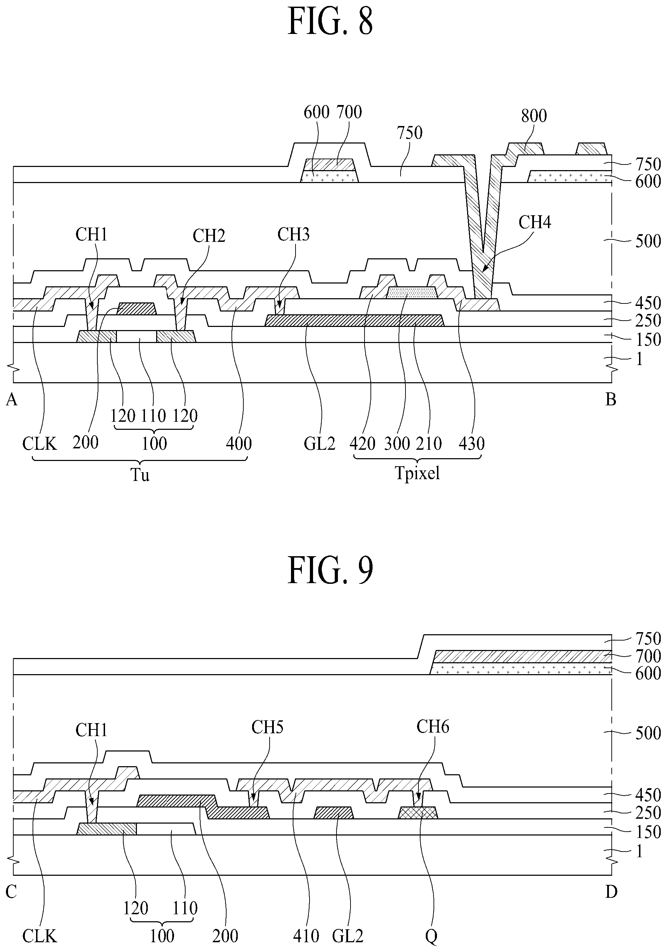

A cross sectional structure of the pixel transistor (Tpixel) and the pull-up transistor (Tu) will be described with reference to FIG. 8.

FIG. 8 is a cross sectional view illustrating the pixel structure of the display device according to one aspect of the present disclosure, which corresponds to a cross section along A-B line of FIG. 7.

As shown in FIG. 8, the pull-up transistor (Tu) and the pixel transistor (Tpixel) are provided on the substrate 1.

The pull-up transistor (Tu) may include a first active layer 100, a first gate electrode 200, a clock signal (CLK) line serving as a first source electrode, and a first drain electrode 400.

The first active layer 100 may include a channel area provided on the substrate 1, and a doping layer 120 disposed at each of both sides of the channel area 110.

The first gate electrode 200 is spaced apart from the active layer 100 by a first gate insulating film 150 interposed in-between. The first gate electrode 200 is positioned at an area corresponding to the channel area 110. In this case, the doping layer 120 may be obtained by doping the first active layer 100 using the first gate electrode 200 as a mask.

The clock signal (CLK) line serving as the first source electrode and the first drain electrode 400 are spaced apart from the first gate electrode 200, wherein a second gate insulating film 250 is interposed between the first gate electrode 200 and the clock signal (CLK) line serving as the first source electrode, and between the first gate electrode 200 and the first drain electrode 400. The clock signal (CLK) line is connected with the doping layer 120 disposed at one side of the channel area 110 via the first contact hole (CH1) provided in the first gate insulating film 150 and the second gate insulating film 250. The first drain electrode 400 is connected with the doping layer 120 disposed at the other side of the channel area 110 via the second contact hole (CH2) provided in the first gate insulating film 150 and the second gate insulating film 250.

The pull-up transistor (Tu) may be formed in a top-gate structure obtained by sequentially depositing the first active layer 100, the first gate insulating film 150, the first gate electrode 200, the second gate insulating film 250, and the clock signal (CLK) line serving as the first source electrode / first drain electrode 400 on the substrate 1. Especially, the first active layer 100 may be manufactured by LTPS (Low-Temperature Polycrystalline Silicon) including a deposition process of amorphous silicon, a process of changing the amorphous silicon to crystalline silicon by laser, and a process of forming the doping layer 120 using the first gate electrode 200 as a mask.

Referring back to FIG. 7, as the pull-up transistor (Tu) is formed by the LTPS (Low-Temperature Polycrystalline Silicon), at least one portion of the active layer 100 may be arranged at the same direction as that of the data line (DL1, DL2), that is, at the longitudinal direction in the area between the adjacent pixels 800 so that it is possible to reduce a problem related with lowering of aperture ratio by the pull-up transistor (Tu).

The first drain electrode 400 of the pull-up transistor (Tu) is connected with the second gate line (GL2), whereby the gate signal is supplied to the second gate line (GL2). In detail, the first drain electrode 400 is connected with the second gate line (GL2) via the third contact hole (CH3) provided in the second gate insulating film 250.

The pixel transistor (Tpixel) may include a second gate electrode 210, a second active layer 300, a second source electrode 420, and a second drain electrode 430.

The second gate electrode 210 is connected with the second gate line (GL2). The second gate electrode 210 of the pixel transistor (Tpixel), the second gate line (GL2), and the first gate electrode 200 of the pull-up transistor (Tu) are formed of the same material, and are provided in the same layer.

The second active layer 300 is spaced apart from the second gate electrode 210 by the second gate insulating film 250 interposed in-between. The second active layer 300 may be formed of an oxide semiconductor, but not limited to this material.

The second source electrode 420 and the second drain electrode 430 are provided on the second active layer 300, wherein the second source electrode 420 and the second drain electrode 430 are spaced apart from each other. The second drain electrode 430 and second source electrode 420 of the pixel transistor (Tpixel), and the first drain electrode 400 and clock signal (CLK) line of the pull-up transistor (Tu) may be formed of the same material, and may be provided at the same layer.

Unlike the aforementioned pull-up transistor (Tu), the pixel transistor (Tpixel) may be formed in a bottom-gate structure obtained by sequentially depositing the second gate electrode 210, the second gate insulating film 250, the second active layer 300, and the second source electrode 420 / second drain electrode 430 on the first gate insulating film 150. Especially, when the second active layer 300 is formed of an oxide semiconductor, it is possible to improve picture quality by decreasing a leakage current of the pixel transistor (Tpixel), and reducing power consumption by a low-speed driving.

A passivation layer 450 is provided on the pixel transistor (Tpixel) and the pull-up transistor (Tu), and a planarization layer 500 is provided on the passivation layer 450.

A common electrode 600 is provided on the planarization layer 500, and a metal line 700 is provided on the common electrode 600. The common electrode 600 is not formed in the area of the pixel transistor (Tpixel) and the pull-up transistor (Tu). The metal line 700 lowers a resistance of the common electrode 600. The common electrode 600 is provided in an open area through which light passes. Thus, the common electrode 600 is formed of a transparent conductive oxide having a relatively high. Accordingly, the resistance of the common electrode 600 is lowered by the metal line 700. The metal line 700 is not provided in the open area, but provided in an area through which light does not pass, for example, an area overlapped with the gate line (GL1, GL2) or data line (DL1, DL2).

An insulating interlayer 750 is provided on the common electrode 600 and the metal line 700, and a pixel electrode 800 is provided on the insulating interlayer 750. The pixel electrode 800 is connected with the drain electrode 430 of the pixel transistor (Tpixel) via the fourth contact hole (CH4) provided in the passivation layer 450, the planarization layer 500, and the insulating interlayer 750. A fringe field is formed between the pixel electrode 800 and the common electrode 600, and liquid crystal molecules included in a liquid crystal layer are aligned by the fringe field.

FIG. 9 is a cross sectional view illustrating the pixel structure of the display device according to one aspect of the present disclosure, which corresponds to a cross section along C-D line of FIG. 7. Wherever possible, the same reference numbers will be used throughout the drawings to refer to the same or like parts, and only different parts will be described in detail.

FIG. 9 shows that the gate electrode 200 of the pull-up transistor (Tu) is connected with the pull-up node (Q) line through the connection electrode 410.

As shown in FIG. 9, the second gate line (GL2) is formed between the gate electrode 200 of the pull-up transistor (Tu) and the pull-up node (Q) line. In this case, the gate electrode 200 of the pull-up transistor (Tu), the pull-up node (Q) line, and the second gate line (GL2) are provided at the same layer. Accordingly, the connection electrode 410 is provided so as to connect the gate electrode 200 of the pull-up transistor (Tu) with the pull-up node (Q) line while being not shorted to the second gate line (GL2).

The connection electrode 410 is provided on the first gate insulating film 250, the connection electrode 410 is connected with the gate electrode 200 of the pull-up transistor (Tu) via the fifth contact hole (CH5) provided in the first gate insulating film 250, and the connection electrode 410 is connected with the pull-up node (Q) line via the sixth contact hole (CH6) provided in the first gate insulating film 250.

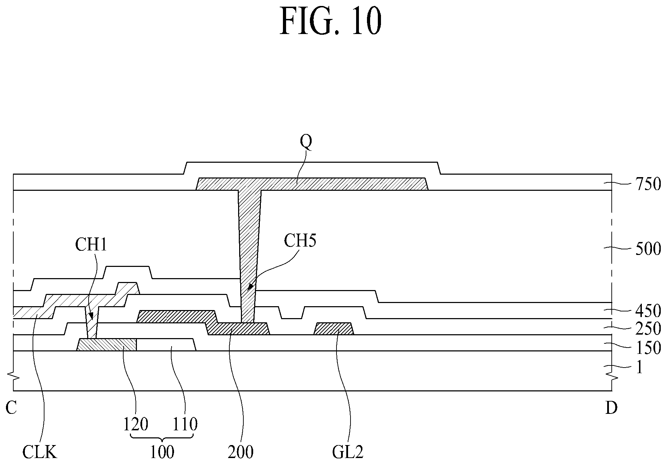

FIG. 10 is a cross sectional view illustrating the pixel structure of the display device according to another aspect of the present disclosure, which corresponds to a cross section along C-D line of FIG. 7.

In FIG. 9, the pull-up node (Q) line and the second gate line (GL2) are formed at the same layer. Meanwhile, in FIG. 10, the pull-up node (Q) line is not formed at the same layer as the second gate line (GL2). In detail, the pull-up node (Q) line and the metal line 700 are formed of the same material, and are manufactured by the same process. Thus, the pull-up mode (Q) line is provided on the planarization layer 500. Unlike the aforementioned case of FIG. 9, the case of FIG. 10 does not need the additional connection electrode 410. Instead, the pull-up node (Q) line may be directly connected with the gate electrode 200 of the pull-up transistor (Tu) via the fifth contact hole (CH5).

Meanwhile, in case of FIG. 10, the common electrode 600 and the metal line 700 are not formed in the area adjacent to the pull-up node (Q) line so as to facilitate the process for the pull-up node (Q) line.

Except that the clock signal (CLK) line is changed into the low-potential voltage (VSS) line, the connection structure between the pull-down node (QB) line and the pull-down transistor (Td) is the same as the aforementioned connection structure between the pull-up node (Q) line and the pull-up transistor (Tu).

The aforementioned description relates to a fringed field switching (FFS) mode liquid crystal display device in which liquid crystal is driven by the fringe field between the pixel electrode 800 and the common electrode 600, but not limited to this type. The present disclosure may be applied to various modes of liquid crystal display device, for example, In-Plane Switching (IPS) mode, Twisted Nematic (TN) mode, Vertical Alignment (VA) mode, and etc. Also, the present disclosure may be applied to an organic light emitting display device.

According to the present disclosure, the GIP circuit is provided in the display area so that it is possible to decrease the size of non-display area, and to decrease the bezel width of the display device.

Especially, the transistor for the GIP circuit is disposed in the area corresponding to the boundaries between the pixels, that is, the area in which the data line is not formed, so that it is possible to prevent the aperture ratio from being lowered by the GIP circuit.

It will be apparent to those skilled in the art that various modifications and variations can be made in the present disclosure without departing from the scope of the disclosures. Thus, it is intended that the present disclosure covers the modifications and variations of this disclosure provided they come within the scope of the appended claims.

## Claims

1. A display device comprising:
a substrate (1) including a display area (DA) and a non-display area (NDA) surrounding the display area (DA);
a plurality of gate lines (GL) arranged along a first direction on the display area, wherein the plurality of gate lines (GL) are arranged in parallel to each other;
a plurality of data lines (DL) arranged along a second direction on the display area, wherein the plurality of data lines (DL) are arranged in parallel to each other;
a plurality of pairs of pixels, located in pixel regions that are defined by crossing of the plurality of gate and the plurality of data lines; wherein each pair of pixels includes:
a first pixel and a second pixel which are adjacent to each other and are arranged in parallel to each other along a second direction, and the first pixel is connected to the data line to its left and the gate line below it, the second pixel is connected to the data line to its right and the gate line above it;
a plurality of gate in panel (GIP) circuits, each GIP circuit of the plurality of GIP circuits is provided on the display area (DA), and supplies a gate signal to a respective gate line among the plurality of gate lines;
wherein each GIP circuit comprises:
a pull-up transistor (Tu) disposed between a pair of pixels of the plurality of pairs of pixels;
a pull-down transistor (Td) disposed between a different pair of pixels;
a node controller (NC) comprising a pull-up node controller (NC_Q) configured to control the charging and discharging states of a pull-up node (Q), and a pull-down node controller (NC_QB) configured to control the charging and discharging states of a pull-down node (QB);
a clock signal line (CLK) provided between a pair of pixels and arranged in the second direction, wherein the signal line (CLK) functions as a first source electrode of the pull-up transistor;
a low-potential voltage (VSS) line;
a start signal (Vst) line; and
a discharging signal (V_{QB});
wherein a pull-up node (Q) line is connected with the first gate electrode (200) of each pull-up transistor (Tu), and a pull-down node (QB) is connected to the gate electrode of each pull-down transistor (Td), and
two pixel transistors (Tpixel) provided in each pair of pixels located in pixel regions defined by crossing of the plurality of gate and data lines wherein one of the two pixel transistors (Tpixel) is connected to the data line to its left and the gate line below it, the other of the two pixel transistors (Tpixel) is connected to the data line to its right and the gate line above it; the pull-up transistor included in the GIP circuit has a structure different from that of the two pixel transistors (Tpixel), and the GIP circuit does not include the two pixel transistors (Tpixel),
wherein the pull-up transistor (Tu) comprises:
a first active layer (100) provided on the substrate (1), the first active layer (100) including a channel area (110), and a doping layer (120) disposed at both sides of the channel area (110);
a first gate insulating film (150) provided on the first active layer (100);
a first gate electrode (200) provided on the first gate insulating film (150);
a second gate insulating film (250) provided on the first gate electrode (200); and
a first source electrode and a first drain electrode (400) disposed on the second gate insulating film (250) and connected with the doping layer (120) of the first active layer (100) via first and second contact holes (CH1, CH2); and
wherein the two pixel transistors (Tpixel) comprise:
a second gate electrode (210) provided on the first gate insulating film (150);
the second gate insulating film (250) provided on the second gate electrode (210);
a second active layer (300) provided on the second gate insulating film (250); and
a second source electrode (420) and a second drain electrode (430) provided on the second active layer (300),
wherein each pull-up node (Q) line and the plurality of gate lines (GL) are formed of the same material, and are provided at the same layer, and each pull-up node (Q) line and the first gate electrode (200) are connected with each other through a connection electrode (410),
and the connection electrode (410) is provided on a different layer than the pull-up nodes (Q) and the plurality of gate lines (GL).

2. The display device according to claim 1, wherein none of the plurality of data lines (DL) is provided between any pair of pixels located in pixel regions defined by crossing of the plurality of gate and data lines.

3. The display device according to claim 1, wherein the first active layer (100) is formed of crystalline silicon and the second active layer (300) is formed of oxide semiconductor.

4. The display device according to claim 1, wherein the pull-up transistor (Tu) includes:
a first drain electrode (400) connected with one of gate lines among the plurality of gate lines (GL); and
the first active layer (100) is connected with the signal line (CLK) and the first drain electrode (400), wherein at least a portion of the first active layer (100) is arranged along the second direction between the adjacent pixels.

5. The display device according to claim 1, wherein the GIP circuit comprises a first GIP circuit (GIP1) supplying a gate signal to a first gate line (GL1) among the plurality of gate lines, and a second GIP circuit (GIP2) supplying the gate signal to a second gate line (GL2) among the plurality of gate lines (GL).

6. The display device according to claim 5, wherein a first GIP circuit (GIP1) and a second GIP circuit (GIP2) of the plurality of GIP circuits are not overlapped with each other in the second direction.

## Patentansprüche

1. Anzeigevorrichtung, die Folgendes umfasst:
ein Substrat (1), das einen Anzeigebereich (DA) und einen Nicht-Anzeigebereich (NDA), der den Anzeigebereich (DA) umgibt, aufweist;
eine Vielzahl von Gate-Leitungen (GL), die entlang einer ersten Richtung auf dem Anzeigebereich angeordnet sind, wobei die Vielzahl von Gate-Leitungen (GL) parallel zueinander angeordnet sind;
eine Vielzahl von Datenleitungen (DL), die entlang einer zweiten Richtung auf dem Anzeigebereich angeordnet sind, wobei die Vielzahl von Datenleitungen (DL) parallel zueinander angeordnet sind;
eine Vielzahl von Pixelpaaren, die sich in Pixelbereichen befinden, die durch Kreuzen der Vielzahl von Gate- und der Vielzahl von Datenleitungen definiert sind; wobei jedes Pixelpaar Folgendes aufweist:
ein erstes Pixel und ein zweites Pixel, die aneinander angrenzen und entlang einer zweiten Richtung parallel zueinander angeordnet sind, und das erste Pixel mit der Datenleitung links davon und der Gate-Leitung darunter verbunden ist, das zweite Pixel mit der Datenleitung rechts davon und der Gate-Leitung darüber verbunden ist; eine Vielzahl von Gate-in-Panel-(GIP)-Schaltungen, wobei jede GIP-Schaltung der Vielzahl von GIP-Schaltungen auf dem Anzeigebereich (DA) bereitgestellt ist und ein Gate-Signal an eine jeweilige Gate-Leitung unter der Vielzahl von Gate-Leitungen liefert;
wobei jede GIP-Schaltung Folgendes umfasst:
einen Pull-up-Transistor (Tu), der zwischen einem Pixelpaar der Vielzahl von Pixelpaaren angeordnet ist;
einen Pull-down-Transistor (Td), der zwischen einem unterschiedlichen Pixelpaar angeordnet ist;
eine Knotensteuerung (NC), die eine Pull-up-Knotensteuerung (NC_Q) umfasst, die dazu ausgelegt ist, die Lade- und Entladezustände eines Pull-up-Knotens (Q) zu steuern, sowie eine Pull-down-Knotensteuerung (NC_QB), die dazu ausgelegt ist, die Lade- und Entladezustände eines Pull-down-Knotens (QB) zu steuern; eine Taktsignalleitung (CLK), die zwischen einem Paar von Pixeln bereitgestellt und in der zweiten Richtung angeordnet ist, wobei die Signalleitung (CLK) als eine erste Source-Elektrode des Pull-up-Transistors fungiert;
eine Niederpotentialspannungs-(VSS)-Leitung;
eine Startsignal-(Vst)-Leitung; und
ein Entladesignal (V_{QB});
wobei eine Pull-up-Knoten-(Q)-Leitung mit der ersten Gate-Elektrode (200) jedes Pull-up-Transistors (Tu) verbunden ist und ein Pull-down-Knoten (QB) mit der Gate-Elektrode jedes Pull-down-Transistors (Td) verbunden ist, und
zwei Pixeltransistoren (Tpixel), die in jedem Paar von Pixeln bereitgestellt sind, die sich in Pixelbereichen befinden, die durch Kreuzen der Vielzahl von Gate- und Datenleitungen definiert sind, wobei einer der zwei Pixeltransistoren (Tpixel) mit der Datenleitung links davon und der Gate-Leitung darunter verbunden ist, der andere der zwei Pixeltransistoren (Tpixel) mit der Datenleitung rechts davon und der Gate-Leitung darüber verbunden ist; der Pull-up-Transistor, der in der GIP-Schaltung enthalten ist, eine Struktur aufweist, die sich von der der zwei Pixeltransistoren (Tpixel) unterscheidet, und die GIP-Schaltung die zwei Pixeltransistoren (Tpixel) nicht beinhaltet,
wobei der Pull-up-Transistor (Tu) Folgendes umfasst:
eine erste aktive Schicht (100), die auf dem Substrat (1) bereitgestellt ist, wobei die erste aktive Schicht (100) einen Kanalbereich (110) beinhaltet, und eine Dotierungsschicht (120), die auf beiden Seiten des Kanalbereichs (110) angeordnet ist;
einen ersten Gate-Isolierfilm (150), der auf der ersten aktiven Schicht (100) vorgesehen ist;
eine erste Gate-Elektrode (200), die auf dem ersten Gate-Isolierfilm (150) vorgesehen ist;
einen zweiten Gate-Isolierfilm (250), der auf der ersten Gate-Elektrode (200) vorgesehen ist; und
eine erste Source-Elektrode und eine erste Drain-Elektrode (400), die auf dem zweiten Gate-Isolierfilm (250) angeordnet und über erste und zweite Kontaktlöcher (CH1, CH2) mit der Dotierungsschicht (120) der ersten aktiven Schicht (100) verbunden sind; und
wobei die zwei Pixeltransistoren (Tpixel) Folgendes umfassen:
eine zweite Gate-Elektrode (210), die auf dem ersten Gate-Isolierfilm (150) vorgesehen ist;
den zweiten Gate-Isolierfilm (250), der auf der zweiten Gate-Elektrode (210) vorgesehen ist;
eine zweite aktive Schicht (300), die auf dem zweiten Gate-Isolierfilm (250) vorgesehen ist; und
eine zweite Source-Elektrode (420) und eine zweite Drain-Elektrode (430), die auf der zweiten aktiven Schicht (300) vorgesehen sind,
wobei jede Pull-up-Knoten-(Q)-Leitung und die Vielzahl von Gate-Leitungen (GL) aus demselben Material gebildet sind und an derselben Schicht vorgesehen sind und jede Pull-up-Knoten-(Q)-Leitung und die erste Gate-Elektrode (200) durch eine Verbindungselektrode (410) miteinander verbunden sind,
und die Verbindungselektrode (410) auf einer anderen Schicht als die Pull-up-Knoten (Q) und die Vielzahl von Gate-Leitungen (GL) vorgesehen ist.

2. Anzeigevorrichtung nach Anspruch 1, wobei keine der Vielzahl von Datenleitungen (DL) zwischen einem beliebigen Paar von Pixeln vorgesehen ist, die sich in Pixelbereichen befinden, die durch Kreuzen der Vielzahl von Gate- und Datenleitungen definiert sind.

3. Anzeigevorrichtung nach Anspruch 1, wobei die erste aktive Schicht (100) aus kristallinem Silizium gebildet ist und die zweite aktive Schicht (300) aus Oxidhalbleiter gebildet ist.

4. Anzeigevorrichtung nach Anspruch 1, wobei der Pull-up-Transistor (Tu) Folgendes aufweist:
eine erste Drain-Elektrode (400), die mit einer der Gate-Leitungen unter der Vielzahl von Gate-Leitungen (GL) verbunden ist; und
wobei die erste aktive Schicht (100) mit der Signalleitung (CLK) und der ersten Drain-Elektrode (400) verbunden ist, wobei mindestens ein Teil der ersten aktiven Schicht (100) entlang der zweiten Richtung zwischen den benachbarten Pixeln angeordnet ist.

5. Anzeigevorrichtung nach Anspruch 1, wobei die GIP-Schaltung eine erste GIP-Schaltung (GIP1), die ein Gate-Signal an eine erste Gate-Leitung (GL1) unter der Vielzahl von Gate-Leitungen liefert, und eine zweite GIP-Schaltung (GIP2), die das Gate-Signal an eine zweite Gate-Leitung (GL2) unter der Vielzahl von Gate-Leitungen (GL) liefert, umfasst.

6. Anzeigevorrichtung nach Anspruch 5, wobei eine erste GIP-Schaltung (GIP1) und eine zweite GIP-Schaltung (GIP2) der Vielzahl von GIP-Schaltungen in der zweiten Richtung nicht miteinander überlappen.

## Revendications

1. Dispositif d'affichage comprenant :
un substrat (1) comportant une zone d'affichage (DA) et une zone hors affichage (NDA) entourant la zone d'affichage (DA) ;
une pluralité de lignes de grille (GL) agencées suivant une première direction sur la zone d'affichage, la pluralité de lignes de grille (GL) étant agencées parallèlement les unes aux autres ;
une pluralité de lignes de données (DL) agencées suivant une deuxième direction sur la zone d'affichage, la pluralité de lignes de données (DL) étant agencées parallèlement les unes aux autres ;
une pluralité de paires de pixels, situées dans des régions de pixels définies par l'intersection de la pluralité de lignes de grille et de la pluralité de lignes de données ; chaque paire de pixels comportant :
un premier pixel et un deuxième pixel qui sont adjacents l'un à l'autre et sont agencés parallèlement l'un à l'autre suivant une deuxième direction, et le premier pixel étant connecté à la ligne de données située à sa gauche et à la ligne de grille située au-dessous de lui, le deuxième pixel étant connecté à la ligne de données située à sa droite et à la ligne de grille située au-dessus de lui ;
une pluralité de circuits GIP (Gate In Panel), chaque circuit GIP de la pluralité de circuits GIP étant prévu sur la zone d'affichage (DA) et fournissant un signal de grille à une ligne de grille respective parmi la pluralité de lignes de grille ;
chaque circuit GIP comprenant :
un transistor de tirage vers le haut (Tu) disposé entre une paire de pixels de la pluralité de paires de pixels ;
un transistor de tirage vers le bas (Td) disposé entre une paire différente de pixels ;
un contrôleur de nœuds (NC) comprenant un contrôleur de nœud de tirage vers le haut (NC_Q) configuré pour commander les états de charge et de décharge d'un nœud de tirage vers le haut (Q), et un contrôleur de nœud de tirage vers le bas (NC_QB) configuré pour commander les états de charge et de décharge d'un nœud de tirage vers le bas (QB) ;
une ligne de signal d'horloge (CLK) prévue entre une paire de pixels et agencée dans la deuxième direction, la ligne de signal (CLK) faisant office de première électrode de source du transistor de tirage vers le haut ;
une ligne de tension à bas potentiel (VSS) ;
une ligne de signal de démarrage (Vst) ; et
un signal de décharge (V_{QB}) ;
une ligne de nœud de tirage vers le haut (Q) étant connectée à la première électrode de grille (200) de chaque transistor de tirage vers le haut (Tu), et un nœud de tirage vers le bas (QB) étant connecté à l'électrode de grille de chaque transistor de tirage vers le bas (Td), et
deux transistors de pixel (Tpixel) prévus dans chaque paire de pixels située dans des régions de pixels définies par l'intersection de la pluralité de lignes de grille et de données, l'un des deux transistors de pixel (Tpixel) étant connecté à la ligne de données située à sa gauche et à la ligne de grille située au-dessous de lui, l'autre des deux transistors de pixel (Tpixel) étant connecté à la ligne de données située à sa droite et à la ligne de grille située au-dessus de lui ; le transistor de tirage vers le haut compris dans le circuit GIP présentant une structure différente de celle des deux transistors de pixel (Tpixel), et le circuit GIP ne comportant pas les deux transistors de pixel (Tpixel),
le transistor de tirage vers le haut (Tu) comprenant :
une première couche active (100) prévue sur le substrat (1), la première couche active (100) comportant une zone de canal (110), et une couche de dopage (120) disposée des deux côtés de la zone de canal (110) ;
un premier film isolant de grille (150) prévu sur la première couche active (100) ;
une première électrode de grille (200) prévue sur le premier film isolant de grille (150) ;
un deuxième film isolant de grille (250) prévu sur la première électrode de grille (200) ; et
une première électrode de source et une première électrode de drain (400) disposées sur le deuxième film isolant de grille (250) et connectées à la couche de dopage (120) de la première couche active (100) par l'intermédiaire de premier et deuxième trous de contact (CH1, CH2) ; et
les deux transistors de pixel (Tpixel) comprenant :
une deuxième électrode de grille (210) prévue sur le premier film isolant de grille (150) ;
le deuxième film isolant de grille (250) prévu sur la deuxième électrode de grille (210) ;
une deuxième couche active (300) prévue sur le deuxième film isolant de grille (250) ; et
une deuxième électrode de source (420) et une deuxième électrode de drain (430) prévues sur la deuxième couche active (300),
chaque ligne de nœud de tirage vers le haut (Q) et la pluralité de lignes de grille (GL) étant formées du même matériau et étant prévues au niveau de la même couche, et chaque ligne de nœud de tirage vers le haut (Q) et la première électrode de grille (200) étant connectées l'une à l'autre par l'intermédiaire d'une électrode de connexion (410),
et l'électrode de connexion (410) étant prévue sur une couche différente de celle des nœuds de tirage vers le haut (Q) et de la pluralité de lignes de grille (GL).

2. Dispositif d'affichage selon la revendication 1, dans lequel aucune de la pluralité de lignes de données (DL) n'est prévue entre une paire quelconque de pixels située dans des régions de pixels définies par l'intersection de la pluralité de lignes de grille et de données.

3. Dispositif d'affichage selon la revendication 1, dans lequel la première couche active (100) est formée de silicium cristallin et la deuxième couche active (300) est formée d'un semi-conducteur d'oxyde.

4. Dispositif d'affichage selon la revendication 1, dans lequel le transistor de tirage vers le haut (Tu) comporte :
une première électrode de drain (400) connectée à l'une des lignes de grille parmi la pluralité de lignes de grille (GL) ; et
la première couche active (100) est connectée à la ligne de signal (CLK) et à la première électrode de drain (400), au moins une partie de la première couche active (100) étant agencée suivant la deuxième direction entre les pixels adjacents.

5. Dispositif d'affichage selon la revendication 1, dans lequel le circuit GIP comprend un premier circuit GIP (GIP1) fournissant un signal de grille à une première ligne de grille (GL1) parmi la pluralité de lignes de grille, et un deuxième circuit GIP (GIP2) fournissant le signal de grille à une deuxième ligne de grille (GL2) parmi la pluralité de lignes de grille (GL).

6. Dispositif d'affichage selon la revendication 5, dans lequel un premier circuit GIP (GIP1) et un deuxième circuit GIP (GIP2) de la pluralité de circuits GIP ne se chevauchent pas l'un l'autre dans la deuxième direction.
